# EUROPÄISCHE PATENTSCHRIFT

(11) **EP 2 639 954 B1**
(45) Veröffentlichungstag und Bekanntmachung des Hinweises auf die Patenterteilung: **21.05.2025**
(21) Anmeldenummer: 12007441.4
(22) Anmeldetag: 31.10.2012
(51) Int. Cl.: H02M 7/162, B23K 11/24, B23K 11/25

(54) **VERFAHREN UND STEUERGERÄT ZUM LADEN EINES ZWISCHENKREISKONDENSATORS FÜR EIN SCHWEISSGERÄT**
METHOD AND CONTROL DEVICE FOR CHARGING AN INTERMEDIATE CIRCUIT CAPACITOR FOR A WELDING DEVICE
PROCÉDÉ ET APPAREIL DE COMMANDE POUR CHARGER UN CONDENSATEUR DE CIRCUIT INTERMÉDIAIRE POUR UN APPAREIL DE SOUDAGE

(30) Priorität: 24.12.2011 DE 102011122409; 23.03.2012 DE 102012005959
(43) Veröffentlichungstag der Anmeldung: 18.09.2013
(73) Patentinhaber: Robert Bosch GmbH, 70442 Stuttgart (DE)
(72) Erfinder: SCHOLZ, Reinhard, 64711 Erbach (DE)

(56) Entgegenhaltungen:
- CN-A- 102 130 616
- US-A- 4 965 860
- US-A- 6 038 155

## Beschreibung

Die vorliegende Erfindung bezieht sich auf ein Verfahren zum Laden eines Zwischenkreiskondensators für ein Schweißgerät, auf ein Steuergerät zum Laden eines Zwischenkreiskondensators für ein Schweißgerät sowie auf ein entsprechendes Computerprogramm.

Ein Widerstandsschweißgerät weist meist eine Zwischenkreis-Elko-Batterie auf. Diese Elkos können nicht direkt mit dem Netz verbunden werden, sondern werden erst mit kleinem Strom geladen. Diese Vorladung kann durch einen Leistungsvorwiderstand erfolgen, der den Strom begrenzt. Die Elkos können auch von einem Ladenetzteil geladen werden, das z. B. mit einem konstanten Strom die Elkos lädt.

Das Dokument US 4 965 860 A offenbart eine Schweißstromeinheit mit einer Kapazität.

Das Dokument CN 102 130 010 A offenbart ein Verfahren zum Verfüllen tiefer Trenches mit hochqualitativem Oxid für Halbleiterbauelemente.

Das Dokument US 6 038 155 offenbart eine 3-Phasen-SCR-Gleichrichterbrücke mit einem Sanft-Start-Steuerungs-IC.

Vor diesem Hintergrund ist es die Aufgabe der vorliegenden Erfindung, ein Verfahren zum Laden eines Zwischenkreiskondensators für ein Schweißgerät, ein Steuergerät zum Laden eines Zwischenkreiskondensators für ein Schweißgerät sowie ein entsprechendes Computerprogramm zu schaffen.

Diese Aufgabe wird durch ein Verfahren zum Laden eines Zwischenkreiskondensators für ein Schweißgerät, ein Steuergerät zum Laden eines Zwischenkreiskondensators für ein Schweißgerät sowie ein entsprechendes Computerprogrammprodukt gemäß den Hauptansprüchen gelöst.

Der vorliegenden Erfindung liegt die Erkenntnis zugrunde, dass unter Verwendung einer Phasenanschnittsteuerung bzw. einer Phasenabschnittsteuerung ein Ladestrom eines Zwischenkreiskondensators begrenzt werden kann. Die Phasenanschnitte bzw. Phasenabschnitte werden sukzessive größer, um eine elektrische Spannung am Zwischenkreiskondensator kontrolliert zu erhöhen.

Vorteilhafterweise kann der Zwischenkreiskondensator bzw. alternativ oder ergänzend die Phasenabschnittsteuerung verlustarm geladen werden. Weiterhin können gesonderte Vorrichtungen zum Bereitstellen eines begrenzten Ladestroms entfallen. Dadurch kann ein Schweißgerät kompakt aufgebaut werden und kostengünstig bereitgestellt werden.

Die vorliegende Erfindung schafft ein Verfahren zum Laden eines Zwischenkreiskondensators für ein Schweißgerät, wobei das Verfahren die im Anspruch 1 definierten Schritte aufweist.

Die vorliegende Erfindung schafft ferner ein Steuergerät zum Laden eines Zwischenkreiskondensators für ein Schweißgerät, das ausgebildet ist, um die Schritte einer Variante des erfindungsgemäßen Verfahrens in entsprechenden Einrichtungen durchzuführen bzw. umzusetzen. Auch durch diese Ausführungsvariante der Erfindung in Form eines Steuergeräts kann die der Erfindung zugrunde liegende Aufgabe schnell und effizient gelöst werden.

Unter einem Steuergerät kann vorliegend ein elektrisches Gerät verstanden werden, das Sensor- oder Datensignale verarbeitet und in Abhängigkeit davon Steuer- und/oder Datensignale ausgibt. Das Steuergerät kann eine Schnittstelle aufweisen, die hard- und/oder softwaremäßig ausgebildet sein kann. Bei einer hardwaremäßigen Ausbildung können die Schnittstellen beispielsweise Teil eines sogenannten System-ASICs sein, der verschiedenste Funktionen des Steuergeräts beinhaltet. Es ist jedoch auch möglich, dass die Schnittstellen eigene, integrierte Schaltkreise sind oder zumindest teilweise aus diskreten Bauelementen bestehen. Bei einer softwaremäßigen Ausbildung können die Schnittstellen Softwaremodule sein, die beispielsweise auf einem Mikrocontroller neben anderen Softwaremodulen vorhanden sind.

Von Vorteil ist auch ein Computerprogramm mit Programmcode, der auf einem maschinenlesbaren Träger wie einem Halbleiterspeicher, einem Festplattenspeicher oder einem optischen Speicher gespeichert sein kann und zur Durchführung des Verfahrens nach einer der vorstehend beschriebenen Ausführungsformen verwendet wird, wenn das Programm auf einem Computer oder einer Vorrichtung ausgeführt wird.

Unter einem Zwischenkreiskondensator kann ein Elektrolytkondensator oder ein Folienkondensator zum Glätten einer gleichgerichteten Spannung nach einem Gleichrichter und vor einem Wechselrichter verstanden werden. Eine Halbwelle kann ein Bereich eines wellenförmigen Spannungsverlaufs sein. Beispielsweise kann die Halbwelle ein Bereich sein, in dem ein Spannungswert des Spannungsverlaufs ein positives oder negatives Vorzeichen aufweist. Die Halbwelle kann von zwei aufeinanderfolgenden Nulldurchgängen des Spannungsverlaufs begrenzt sein. Der Spannungsverlauf kann eine Wechselspannung sein. Innerhalb der Halbwelle kann die Wechselspannung Phasenwinkel einer halben Wellenlänge aufweisen. An einem Anfang der Halbwelle kann der Phasenwinkel null sein. An einem Ende der Halbwelle kann der Phasenwinkel 180° oder π sein, ebenso kann sich die Halbwelle zwischen 180° bzw. π und 360° bzw. 2π erstrecken. 2π kann erneut als Nullpunkt betrachtet werden. Ebenso kann der Phasenwinkel fortlaufend betrachtet werden. Ein Abschnitt der Halbwelle kann ein Stück der Halbwelle sein. Der Abschnitt kann einen Anfangspunkt mit einem Anfangswinkel, einem Anfangszeitpunkt und einem Anfangs-Spannungswert sowie einen Endpunkt mit einem Endwinkel, einem Endzeitpunkt und einem End-Spannungswert aufweisen. Ein Zündwinkel (der auch als phasenbezogenen Startzeitpunkt, als Startzeitpunkt eines Abschnitts innerhalb einer Halbwelle, bezeichnet werden kann) kann der Anfangswinkel des Abschnitts sein. Unter einem phasenbezogenen Startzeitpunkt kann folglich ein Zeitpunkt bezogen auf den Beginn einer Halbwelle verstanden werden, wobei der in Betracht kommende Abschnitt dann vom Startzeitpunkt bis zum Erreichen einer Spannung von null Volt definiert ist. Der Zündwinkel kann mit einem Phasenwinkel der Halbwelle korrelieren, den die Wechselspannung zu einem Anfangszeitpunkt des Abschnitts aufweist. Der Endpunkt kann ein Nulldurchgang der Wechselspannung sein.

Eine Winkeldifferenz zwischen dem ersten Zündwinkel und dem zweiten Zündwinkel kann kleiner als eine maximale Winkeldifferenz sein. Anders ausgedrückt kann eine Differenz zwischen dem ersten phasenbezogenen Startzeitpunkt und dem zweiten phasenbezogenen Startzeitpunkt kleiner als eine maximal vorgegebene Differenz oder maximal vorgegebene Zeitdauer sein. Eine vorgegebene maximale Winkeldifferenz kann einen zu starken Spannungsanstieg am Zwischenkreiskondensator zwischen den einzelnen Schritten des Einspeisens begrenzen. Dadurch kann der Stromfluss ebenfalls begrenzt werden.

Das Verfahren kann einen Schritt des Bestimmens des ersten phasenbezogenen Startzeitpunkts aufweisen, wobei der erste phasenbezogene Startzeitpunkt unter Verwendung eines maximal zulässigen Stroms am Zwischenkreiskondensator bestimmt wird. Alternativ oder ergänzend kann das Verfahren einen Schritt des Bestimmens des zweiten phasenbezogenen Startzeitpunkts aufweisen, wobei der zweite phasenbezogene Startzeitpunkt unter Verwendung des maximal zulässigen Stroms am Zwischenkreiskondensator bestimmt wird. Ein aktueller Strom am Zwischenkreiskondensator kann in einem Schritt des Messens ermittelt werden. Die phasenbezogenen Startzeitpunktekönnen so bestimmt werden, dass ein Stromanstieg während des Einspeisens kleiner als ein maximal vorgesehener Stromanstieg ist, den der Zwischenkreiskondensator aushalten kann, ohne einen Defekt zu erleiden.

Das Verfahren weist einen Schritt des Ermittelns einer Phasenlage der Halbwelle und einer Phasenlage der nachfolgenden Halbwelle auf, wobei der erste phasenbezogene Startzeitpunkt und der zweite phasenbezogenen Startzeitpunkt in den Schritten des Einspeisens unter Verwendung der Phasenlagen bestimmt werden. Beispielsweise können die Nulldurchgänge oder Maxima ermittelt werden, um die Phasenlage zu ermitteln. Die phasenbezogenen Startzeitpunkte können relativ zur Phasenlage angepasst werden.

Das Verfahren kann einen ersten Schritt des Erfassens einer Spannung des Zwischenkreiskondensators vor dem ersten Schritt des Einspeisens aufweisen, wobei der erste phasenbezogenen Startzeitpunkt unter Verwendung der Spannung vor dem Einspeisen bestimmt wird. Alternativ oder ergänzend kann das Verfahren einen zweiten Schritt des Erfassens der Spannung des Zwischenkreiskondensators nach dem ersten Schritt des Einspeisens aufweisen, wobei der zweite phasenbezogene Startzeitpunkt unter Verwendung der Spannung nach dem ersten Einspeisen bestimmt wird. Eine Spannung des Zwischenkreiskondensators kann eine zwischen den Polen des Zwischenkreiskondensators anliegende elektrische Spannung sein.

Der erste phasenbezogene Startzeitpunkt kann einen Spannungswert der Halbwelle repräsentieren, der eine vorbestimmte Spannungsdifferenz größer ist, als die Spannung vor dem ersten Schritt des Einspeisens. Alternativ oder ergänzend kann der zweite phasenbezogene Startzeitpunkt einen Spannungswert der nachfolgenden Halbwelle repräsentieren, der die vorbestimmte Spannungsdifferenz größer ist, als die Spannung nach dem ersten Einspeisen. Dadurch kann ein übergroßer Anstieg der Spannung am Zwischenkreiskondensator zwischen zwei aufeinanderfolgenden Halbwellen verhindert werden.

Die Halbwelle kann einen Teil einer ersten Phase einer Mehrphasenwechselspannung repräsentieren. Die nachfolgende Halbwelle kann einen Teil einer, um einen Phasenwinkel zu der Halbwelle verschobenen zweiten Phase der Mehrphasenwechselspannung repräsentieren. Beispielsweise können bei einer Dreiphasenwechselspannung die Phasen zueinander einen Phasenversatz von 120° oder 2/3π aufweisen. Die Halbwellen können einander überlappen.

Das Verfahren kann zumindest einen weiteren Schritt des Einspeisens aufweisen, in dem eine Spannung eines weitern Abschnitts einer der Halbwelle oder der nachfolgenden Halbwelle weitere nachfolgenden Halbwelle der Wechselspannung in den Zwischenkreiskondensator eingespeist wird, wobei der weitere Abschnitt bei einem weiteren phasenbezogenen Startzeitpunkt beginnt, der früher als der zweite phasenbezogene Startzeitpunkt ist.

Der zumindest eine weitere phasenbezogene Startzeitpunkt kann bis zu einem vorgegebenen Minimalzündwinkel oder minimalen phasenbezogene Startzeitpunkt reduziert werden. Beispielsweise kann bei dem vorgegebenen Minimalzündwinkel oder dem minimalen phasenbezogene Startzeitpunkt ein maximaler Effektivwert der Wechselspannung erreicht sein.

Der zumindest eine weitere phasenbezogene Startzeitpunkt kann so weit verringert werden, bis der Zwischenkreiskondensator eine vorgegebene Spannung aufweist. Die vorgegebene Spannung kann eine Soll-Spannung sein. Beispielsweise kann die vorgegebene Spannung eine Standby-Spannung sein, um Energie zu sparen.

Die vorliegende Erfindung schafft ferner ein Schweißgerät mit folgenden Merkmalen:
einem zumindest halbgesteuerten Gleichrichter zum Erzeugen einer Gleichspannung,
einem Zwischenkreiskondensator zum Glätten der Gleichspannung, wobei ein positiv aufladbarer Kontakt des Zwischenkreiskondensators mit einem eine positive Spannung abgebenden Anschluss des Gleichrichters verbunden ist, und wobei ein negativ aufladbarer Kontakt des Zwischenkreiskondensators mit einem eine negative Spannung ausgebenden Anschluss des Gleichrichters verbunden ist;
einem Steuergerät zum Laden des Zwischenkreiskondensators gemäß dem hier vorgestellten Ansatz; und
einer Einrichtung zum Erzeugen eines Schweißstroms, die mit dem Zwischenkreiskondensator verbunden ist, um die Gleichspannung zu verbrauchen.

Die Erfindung wird nachstehend anhand der beigefügten Zeichnungen beispielhaft näher erläutert. Es zeigen:
- Fig. 1: ein Ablaufdiagramm eines Verfahrens zum Laden eines Zwischenkreiskondensators
- Fig. 2: ein Ablaufdiagramm eines Teils eines Verfahrens zum Laden eines Zwischenkreiskondensators
- Fig. 3: eine grafische Darstellung von Spannungsverläufen und Abschnitten mit absteigenden Zündwinkeln in unterschiedlichen aufeinanderfolgenden Halbwellen
- Fig. 4: eine Darstellung eines Schweißgeräts
- Fig. 5: eine Darstellung eines Spannungsverlaufs
- Fig. 6: eine Darstellung eines Spannungsverlaufs

Gleiche oder ähnliche Elemente können in den nachfolgenden Figuren durch gleiche oder ähnliche Bezugszeichen versehen sein. Ferner enthalten die Figuren der Zeichnungen, deren Beschreibung sowie die Ansprüche zahlreiche Merkmale in Kombination. Einem Fachmann ist dabei klar, dass diese Merkmale auch einzeln betrachtet werden oder sie zu weiteren, hier nicht explizit beschriebenen Kombinationen zusammengefasst werden können.

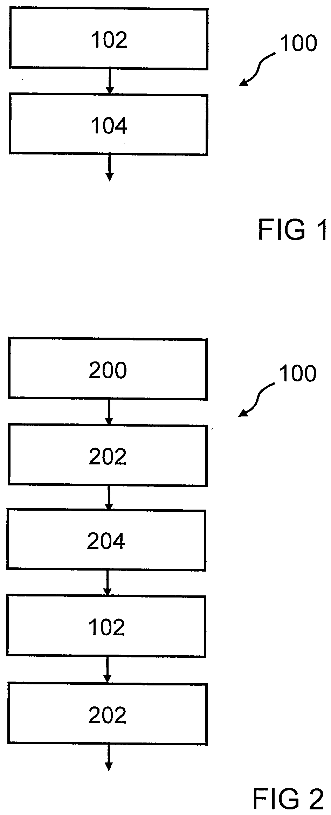

Fig. 1 zeigt ein Ablaufdiagramm eines Verfahrens 100 zum Laden eines Zwischenkreiskondensators eines Schweißgeräts. Das Verfahren weist zwei aufeinanderfolgende Schritte des Einspeisens 102, 104 auf. Im ersten Schritt des Einspeisens 102 wird eine Spannung aus einem ersten Abschnitt einer Halbwelle einer Wechselspannung in den Zwischenkreiskondensator eingespeist, wobei der erste Abschnitt bei einem ersten phasenbezogenen Startzeitpunkt beginnt. Im darauffolgenden zweiten Schritt des Einspeisens wird eine Spannung aus einem zweiten Abschnitt einer nachfolgenden Halbwelle der Wechselspannung in den Zwischenkreiskondensator eingespeist, wobei der zweite Teil bei einem zweiten phasenbezogenen Startzeitpunkt beginnt, der früher als der erste phasenbezogene Startzeitpunkt ist. Bezogen auf eine Zündwinkelbetrachtung bedeutet dies, dass der zweite phasenbezogene Startzeitpunkt kleiner als der erste phasenbezogenen Startzeitpunkt ist.

Fig. 2 zeigt ein Ablaufdiagramm eines Teils eines Verfahrens 100 zum Laden eines Zwischenkreiskondensators. In dem Teil weist das Verfahren 100 einen Schritt des Ermittelns 200, einen Schritt des Messens 202, einen Schritt des Bestimmens 204, einen Schritt des Einspeisens 102 und einen weiteren Schritt des Messens 202 auf. Die Schritte des Verfahrens 100 oder einer Variante davon können in dem Verfahren 100 in Fig. 1 zusätzlich ausgeführt werden. Im Schritt des Ermittelns 200 wird eine Phasenlage der Wechselspannung ermittelt. Hier ist eine Frequenz und Amplitude der Wechselspannung bekannt, da die Wechselspannung eine Netzspannung mit Netzfrequenz ist. Bei einer unbekannten Wechselspannung kann die Frequenz und Amplitude der Wechselspannung ebenfalls im Schritt des Ermittelns erfasst werden. Die Phasenlage wird anhand markanter, charakteristischer Spannungswerte der Wechselspannung ermittelt. Beispielsweise können Nulldurchgänge der Wechselspannung erkannt werden, um die Phasenlage der Wechselspannung zu erkennen. Im Schritt des Messens 202 wird eine Spannung an Anschlüssen des Zwischenkreiskondensators gemessen. Im Schritt des Bestimmens 204 wird der erste Zündwinkel (phasenbezogenen Startzeitpunkt) für ein steuerbares Gleichrichterbauteil bestimmt. In dem Zündwinkel (phasenbezogenen Startzeitpunkt) weist die Wechselspannung einen Wert auf, der um eine vorgegebene Differenz höher ist als die gemessene Spannung am Kondensator, damit Ladung in den Kondensator fließen kann. Im Schritt des Einspeisens 102 wird das Gleichrichterbauteil leitend geschalten, wenn die Wechselspannung den Zündwinkel aufweist. Das Gleichrichterbauteil bleibt leitend, bis die Spannung ihr Vorzeichen umkehrt. Solange die momentane Spannung der Wechselspannung höher ist als die momentane Spannung am Kondensator fließt Ladung in den Kondensator. Im zweiten Schritt des Messens wird die Spannung am Kondensator gemessen, um in dem darauffolgenden, nicht dargestellten Schritt des Bestimmens des zweiten Zündwinkels den Zündwinkel so zu bestimmen, dass in dem ebenfalls nicht dargestellten zweiten Schritt des Einspeisens weitere Ladung in den Kondensator fließen kann. Die Schritte des Verfahrens 100 können so lange ausgeführt werden, bis die Spannung im Zwischenkreiskondensator der effektiven Spannung der Wechselspannung entspricht. Ebenso kann die Spannung im Zwischenkreiskondensator auf einen vorgegebenen Wert begrenzt sein.

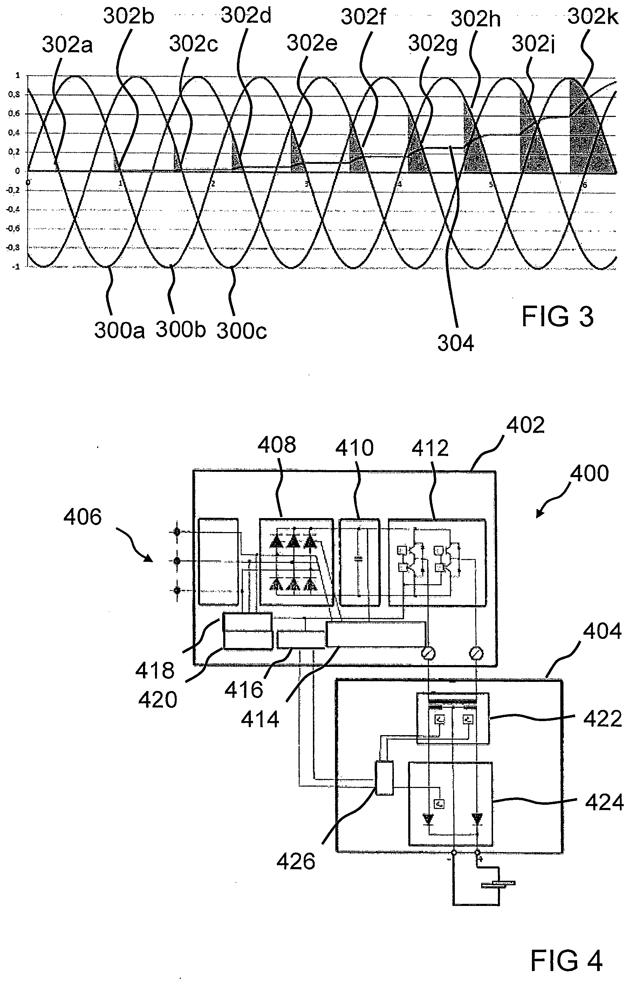

Fig. 3 zeigt eine grafische Darstellung von Spannungsverläufen 300 und Abschnitten 302 mit absteigenden (d. h. kleiner werdenden) Zündwinkeln gemäß einem Ausführungsbeispiel der vorliegenden Erfindung. Weiterhin zeigt die Darstellung eine ansteigende Spannung 304 am Zwischenkreiskondensator. Die hier dargestellten Spannungen aus den Abschnitten 302a bis 302k können mittels eines Verfahrens gemäß dem hier vorgestellten Ansatz in den Zwischenkreiskondensator eines Schweißgeräts eingespeist werden, um hierin die Spannung 304 zu erhöhen, während ein Stromfluss am Kondensator begrenzt ist.

Dargestellt sind die Spannungsverläufe 300, die Abschnitte 302 und die Spannung 304 in einem Diagramm, das als Abszisse einen Phasenwinkel der Spannungsverläufe 300 in Bogenmaß (π) aufweist. Auf der Ordinate ist ein auf eins normierter Spannungswert von minus eins über null bis plus eins angetragen. Die Abszisse beginnt bei 0π und ist bis über 6π hinaus dargestellt. Die Spannungsverläufe 300a, 300b und 300c repräsentieren die drei Phasen L1, L2 und L3 einer Dreiphasenwechselspannung. Sie weisen eine sinusförmige Gestalt mit einer Wellenlänge von 2π und einer Amplitude von 1 auf. Zueinander sind die Spannungsverläufe 300 um 120° bzw. 2/3π versetzt. Alle Spannungsverläufe 300 sind über drei komplette Wellenlängen dargestellt. Eine Wellenlänge ist in eine positive Halbwelle mit positiven Spannungswerten und einer Länge von 1π und in eine negative Halbwelle mit negativen Spannungswerten und ebenfalls einer Länge von 1π unterteilt. In diesem Ausführungsbeispiel werden zum Einspeisen der Abschnitte 302 nur die positiven Halbwellen verwendet. Ebenso können die negativen Halbwellen oder positive und negative Halbwellen gemeinsam verwendet werden.

Ansprechend auf ein Ladesignal von einem Steuergerät gemäß einem Ausführungsbeispiel der vorliegenden Erfindung wird mittels eines ersten schaltbaren Bauteils (Diode, Thyristor, Transistor, o.Ä.) eines halbgesteuerten Brückengleichrichters (d. h. eines Brückengleichrichters, bei dem nur ein Gleichrichterelement zur Gleichrichtung einer positiven oder negativen Spannung der Wechselspannung vorgesehen ist) ein erster Abschnitt 302a aus einer ersten Halbwelle der Phase 300a in den Zwischenkreiskondensator eingespeist. Der erste Abschnitt 302a weist einen ersten Zündwinkel auf, bei dem das erste Bauteil durchlässig geschalten wird. Der erste Zündwinkel ist geringfügig kleiner als 1π und liegt kurz vor dem Nulldurchgang der Phase 300a. Damit weist der erste Abschnitt 302a eine geringe Anfangsspannung unter 0,1 auf. Die Spannung 304 steigt kaum merklich an. Der zweite Abschnitt 302b wird aus einer nachfolgenden ersten Halbwelle der Phase 300b in den Zwischenkreiskondensator eingespeist. Der zweite Abschnitt 302b weist einem zweiten Zündwinkel auf, der kleiner ist als der erste Zündwinkel. Der zweite Abschnitt 302b weist eine Anfangspannung unter 0,2 auf. Die Spannung 304 am Zwischenkreiskondensator steigt geringfügig an. Der dritte Abschnitt 302c wird aus einer nachfolgenden ersten Halbwelle der Phase 300c in den Zwischenkreiskondensator eingespeist. Der Zündwinkel des dritten Abschnitts 302c ist erneut kleiner als der Zündwinkel des zweiten Abschnitts 302b. Damit ist eine Anfangsspannung des dritten Abschnitts 302d unter 0,3. Die Spannung 304 steigt merklich. Der vierte Abschnitt 302d wird aus einer nachfolgenden zweiten Halbwelle der Phase 300a in den Zwischenkreiskondensator eingespeist. Der Zündwinkel des vierten Abschnitts 302d ist erneut kleiner als der Zündwinkel des dritten Abschnitts 302c. Damit ist eine Anfangsspannung des vierten Abschnitts 302d unter 0,4. Die Spannung 304 steigt. Der fünfte Abschnitt 302e wird aus einer nachfolgenden zweiten Halbwelle der Phase 300b in den Zwischenkreiskondensator eingespeist. Der Zündwinkel des fünften Abschnitts 302e ist erneut kleiner als der Zündwinkel des vierten Abschnitts 302d. Damit ist eine Anfangsspannung des fünften Abschnitts 302e unter 0,5. Die Spannung 304 steigt bis auf 0,1. Der sechste Abschnitt 302f wird aus einer nachfolgenden zweiten Halbwelle der Phase 300c in den Zwischenkreiskondensator eingespeist. Der Zündwinkel des sechsten Abschnitts 302f ist erneut kleiner als der Zündwinkel des fünften Abschnitts 302e. Damit ist eine Anfangsspannung des sechsten Abschnitts 302f unter 0,6. Die Spannung 304 steigt bis knapp unter 0,2. Der siebte Abschnitt 302g wird aus einer nachfolgenden dritten Halbwelle der Phase 300a in den Zwischenkreiskondensator eingespeist. Der Zündwinkel des siebten Abschnitts 302g ist erneut kleiner als der Zündwinkel des sechsten Abschnitts 302f. Damit ist eine Anfangsspannung des siebten Abschnitts 302g unter 0,7. Die Spannung 304 steigt bis knapp unter 0,3. Der achte Abschnitt 302h wird aus einer nachfolgenden dritten Halbwelle der Phase 300b in den Zwischenkreiskondensator eingespeist. Der Zündwinkel des achten Abschnitts 302h ist erneut kleiner als der Zündwinkel des siebten Abschnitts 302g. Damit ist eine Anfangsspannung des achten Abschnitts 302h unter 0,8. Die Spannung 304 steigt bis 0,4. Der neunte Abschnitt 302j wird aus einer nachfolgenden dritten Halbwelle der Phase 300c in den Zwischenkreiskondensator eingespeist. Der Zündwinkel des neunten Abschnitts 302j ist erneut kleiner als der Zündwinkel des achten Abschnitts 302h. Damit ist eine Anfangsspannung des neunten Abschnitts 302j unter 0,9. Die Spannung 304 steigt bis 0,6. Der zehnte Abschnitt 302k wird aus einer nachfolgenden vierten Halbwelle der Phase 300a in den Zwischenkreiskondensator eingespeist. Der Zündwinkel des zehnten Abschnitts 302k ist erneut kleiner als der Zündwinkel des neunten Abschnitts 302j. Damit ist eine Anfangsspannung des zehnten Abschnitts 302k unter 1. Die Spannung 304 steigt bis über 0,9. Der Zwischenkreiskondensator ist jetzt geladen.

Gemäß der Erfindung ermittelt eine übergeordnete Steuerung als erstes im zeitlichen Ablauf den jeweiligen Betriebszustand des Systems. Diese Betriebszustände sind: ein Ladevorgang, ein Erzeugen einer reduzierten Spannung (Standby oder Sleepmodus), ein normaler Betrieb mit minimalem Zündwinkel und ein Ausschalten. Abhängig vom jeweiligen Betriebszustand kann dann eine Ladung des Zwischenkreiskondensators erfolgen, sodass nicht in allen Fällen eine Ladung des Zwischenkreiskondensators erfolgen braucht, sondern je nach Betriebszustand eine unterschiedliche Ladungsmenge in den Zwischenkreiskondensator eingebracht wird (d. h. der Zwischenkreiskondensator auf eine entsprechende Spannung aufgeladen wird).

Fig. 4 zeigt eine Darstellung eines Schweißgeräts 400 gemäß einem Ausführungsbeispiel der vorliegenden Erfindung. Das Schweißgerät ist aus zwei separaten Einheiten aufgebaut, einem Inverter 402 und einem Transformatorgleichrichter 404. Beide sind über elektrische Leitungen miteinander verbunden.

Der Inverter 402 ist mit einem Dreiphasenwechselspannungs-Netz 406 verbunden. Das Dreiphasenwechselspannungs-Netz 406 weist drei Phasen L1, L2 und L3 auf. Der Inverter weist einen halbgesteuerten Brückengleichrichter 408, einen Zwischenkreiskondensator 410, einen Wechselrichter 412, ein Steuergerät 414 gemäß einem Ausführungsbeispiel der vorliegenden Erfindung, einen Schweißprozessor 416 und eine Spannungsversorgungseinrichtung 418 mit einem Treiber 420 auf. Der Brückengleichrichter 408 ist mit dem Netz 406 verbunden und ist dazu ausgebildet, die Wechselspannungen der Phasen L1, L2 und L3 in eine Gleichspannung zu wandeln. Der Zwischenkreiskondensator 410 ist mit dem Brückengleichrichter 408 verbunden und dazu ausgebildet eine Welligkeit der Gleichspannung aus dem Gleichrichter 408 zu reduzieren. Der Wechselrichter 412 ist mit dem Zwischenkreiskondensator 410 verbunden und ist dazu ausgebildet, die Gleichspannung in eine mittelfrequente Wechselspannung zu wandeln. Diese Wechselspannung wird über die elektrischen Leitungen zu dem Transformatorgleichrichter 404 geleitet. Das Steuergerät 414 ist mit dem Netz 406, dem Brückengleichrichter 408 und dem Zwischenkreiskondensator 410 verbunden. Das Steuergerät 414 ist dazu ausgebildet, eine Phasenlage des Netzes 406 zu bestimmen, ein Einspeisen von Halbwellenabschnitten mit veränderlichem Anfangszeitpunkt in den Zwischenkreiskondensator 410 zu steuern und eine Spannung und/oder einen Stromfluss am Zwischenkreiskondensator 410 zu überwachen. Der Schweißprozessor 416 ist über ein Bussystem mit der Spannungsversorgungseinrichtung 418, dem Wechselrichter 412 und dem Transformatorgleichrichter 404 verbunden. Der Schweißprozessor 416 ist dazu ausgebildet, IGBTs (Insulated Gate Bipolar Transistor) des Wechselrichters 412 anzusteuern, um die mittelfrequente Wechselspannung bedarfsgerecht an den Transformatorgleichrichter 404 bereitzustellen.

Der Transformatorgleichrichter 404 weist einen Schweißtransformator 422, einen Gleichrichter 424 und eine Sensorik 426 auf. Der Schweißtrafo 422 ist mit dem Wechselrichter 412 verbunden und ist dazu ausgebildet, einen Strom der mittelfrequenten Wechselspannung auf einen Schweißstrom zu transformieren. Der Gleichrichter 424 ist mit dem Schweißtrafo 422 verbunden und dazu ausgebildet, die mittelfrequente Wechselspannung in eine mittelfrequente Gleichspannung zu wandeln, die für einen Schweißvorgang verwendet werden kann. Die Sensorik 426 weist Sensoren in dem Schweißtrafo 422 und dem Gleichrichter 424 auf und ist zum Übermitteln von Daten mit dem Schweißprozessor 416 verbunden.

Das Steuergerät 414 ist dazu ausgebildet, einen Ladestrom beim Laden des Zwischenkreiskondensators 410 innerhalb einer vorgegebenen Toleranz zu halten, indem mittels einer Pulsweitenmodulation mit ansteigender Pulsweite von dem halbgesteuerten Brückengleichrichter 408 eine ansteigende Ladespannung bereitgestellt wird, wie in Fig. 3 dargestellt ist.

Mit anderen Worten kann mithilfe eines Einsatzes einer halb-gesteuerten B6-Brücke 408 mittels einer spannungsabhängigen Ansteuerung der Thyristoren ein Ladewiderstand bzw. das Ladenetzteil zum Laden des Zwischenkreiskondensators 410 entfallen. Durch die Ansteuerung der Thyristoren ab einem Phasenwinkel von ca. 220·sinkend kann die Vorladefunktion erfüllt werden. Durch den Einsatz der B6-Brücke 408 können Systemverluste verringert werden.

Durch die Ansteuerung der Thyristoren ergibt sich eine einfache und schnelle Ladeschaltung der Zwischenkreis-Elkos 410. Des Weiteren kann mit dieser Steuerung einfach eine Stand-by Funktion mit reduzierter Zwischenkreisspannung oder ein Sleep-Modus mit ausgeschalteter Zwischenkreisspannung umgesetzt werden. Trotzdem ist es möglich, wieder schnell schweißbereit zu sein.

Gemäß einem Ausführungsbeispiel der vorliegenden Erfindung erfolgt die Ansteuerung der halb-gesteuerten Brücke unter Verwendung einer Spannungsmessung der Netzspannungen. Der Zündwinkel der Thyristoren wird aufgrund der Spannungsmessung pro Phase verändert. Alternativ kann der Zündwinkel auch durch eine zeitliche Steuerung verändert werden. Entsprechend einer Differenz zwischen Netzspannung und Zwischenkreisspannung kann der Steuerwinkel in gleichmäßigen Schritten reduziert werden, bis die Thyristoren dann für die erforderlichen 120°·dauernd angesteuert werden.

Die Stand-by Funktion kann beispielsweise durch Regelung der Zwischenkreisspannung auf den halben Spannungswert erreicht werden. Dann wird die halb-gesteuerte Brücke 408 im Ansteuerwinkel wie beim Ladevorgang nur z. B. jede zwanzigste Netzperiode gezündet. Dadurch entstehen weniger Verluste durch Wegfall der Zündenergie während jeder Netzperiode. Weiterhin werden Durchlassverluste der Thyristoren vermieden. Zusätzlich entstehen in den Symmetriewiderständen der Elko-Batterie und durch den geringeren Reststrom der Elkos wesentlich weniger Verluste. Die Stand-by Funktion kann durch eine übergeordnete Steuerung 416 angestoßen werden, unter der Randbedingung, dass das System 400 z. B. nach 50ms wieder schweißbereit ist.

Die Sleep-Funktion kann auch durch die übergeordnete Steuerung 416 aktiviert werden. Während der Sleep-Funktion ist die halb-gesteuerte Brücke 408 ganz gesperrt, so das der Zwischenkreis 410 sich entlädt. Zur erneuten Schweißung kann bei der Sleep-Funktion dann z. B. eine Sekunde vergehen, bis die Zwischenkreisspannung ihren Sollwert erreicht hat. Eine Verzögerung kann auch von dem Wiederbeleben der Steuerung 416 abhängen, die auch in den Sleep-Modus gehen kann.

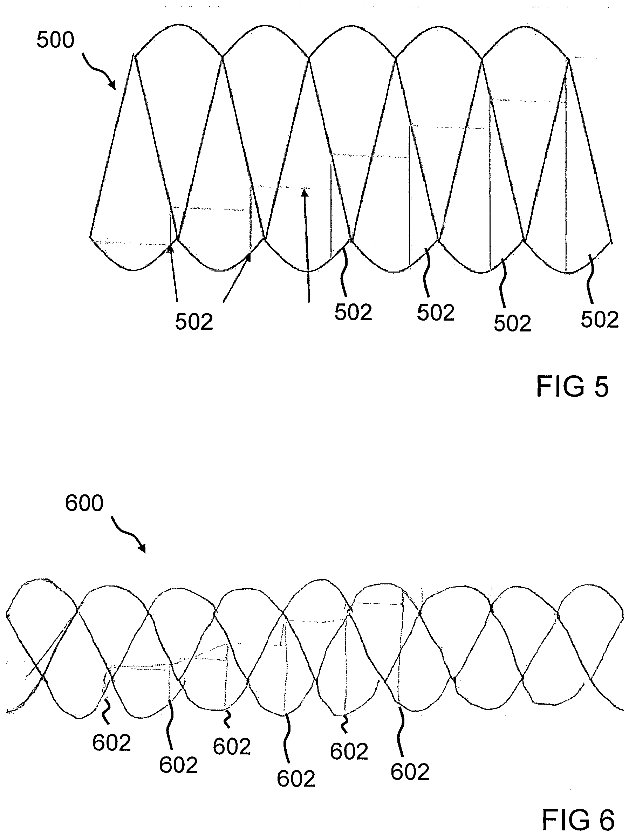

Die Figuren 5 und 6 zeigen prinzipiell den Effekt der Vorverlagerung des Zündzeitpunkts gemäß Ausführungsbeispielen der vorliegenden Erfindung bei näherungsweise sinusförmigen Wechselspannungen.

Fig. 5 zeigt eine Darstellung eines Spannungsverlaufs 500 gemäß einem Ausführungsbeispiel der vorliegenden Erfindung. Analog zu den Spannungsverläufen in Fig. 3 wird eine Dreiphasenwechselspannung 500 bei fallender Flanke zu ansteigenden Anteilen 502 in den Zwischenkreiskondensator eingespeist. Zu Beginn der Anteile 502 wird je ein Thyristor im Gleichrichter gezündet, um durchlässig zu werden. Dadurch steigt die Zwischenkreisspannung 504 in diesem Ausführungsbeispiel näherungsweise linear.

Fig. 6 zeigt eine Darstellung eines Spannungsverlaufs 600 gemäß einem Ausführungsbeispiel der vorliegenden Erfindung. Wie in Fig. 5 sind die kleiner werdenden Zündwinkel 602 dargestellt. Im Gegensatz zu Fig. 5 ist der Verlauf der Spannung am Zwischenkreiskondensator monoton steigend dargestellt.

Die gezeigten Ausführungsbeispiele sind nur beispielhaft gewählt und können miteinander kombiniert werden.

### Bezugszeichenliste

- 100: Verfahren zum Laden
- 102: erster Schritt des Einspeisens
- 104: zweiter Schritt des Einspeisens
- 200: Schritt des Ermittelns
- 202: Schritt des Messens
- 204: Schritt des Bestimmens
- 300: Wechselspannung
- 302: Abschnitt
- 304: Spannung am Zwischenkreiskondensator
- 400: Schweißgerät
- 402: Inverter
- 404: Transformatorgleichrichter
- 406: Dreiphasenwechselspannung
- 408: Brückengleichrichter
- 410: Zwischenkreiskondensator
- 412: Wechselrichter
- 414: Steuergerät zum Laden
- 416: Schweißprozessor
- 418: Spannungsversorgung
- 420: Treiber
- 422: Schweißtransformator
- 424: Gleichrichter
- 426: Sensorik
- 500: Wechselspannung
- 502: Abschnitt
- 600: Wechselspannung
- 602: Zündwinkel

## Patentansprüche

1. Verfahren (100) zum Laden eines Zwischenkreiskondensators (408) für ein Schweißgerät (400), wobei das Verfahren (100) die folgenden Schritte aufweist:
Einspeisen (102) einer Spannung aus einem ersten Abschnitt (302a) einer Halbwelle einer Wechselspannung (300a) in den Zwischenkreiskondensator (410), wobei der erste Abschnitt (302a) bei einem ersten Zündwinkel beginnt; und
Einspeisen (104) einer Spannung aus einem zweiten Abschnitt (302b) einer der Halbwelle nachfolgenden Halbwelle der Wechselspannung (300b) in den Zwischenkreiskondensator (410), wobei der zweite Abschnitt (302b) bei einem zweiten Zündwinkel beginnt, der kleiner als der erste Zündwinkel ist,
**dadurch gekennzeichnet, dass**
als erstes im zeitlichen Ablauf des Verfahrens (100) einer der folgenden vier Betriebszustände eines Systems mit dem Zwischenkreiskondensator (408) mittels einer übergeordneten Steuerung als vorliegend ermittelt wird:
- Ladevorgang
- Erzeugen einer reduzierten Spannung
- normaler Betrieb mit reduziertem Zündwinkel
- Ausschalten
und wobei je nach Betriebszustand eine unterschiedliche Ladungsmenge in den Zwischenkreiskondensator (408) eingebracht wird.

2. Verfahren (100) gemäß Anspruch 1, bei dem im Schritt des Einspeisens (104) des zweiten Abschnitts (302b) eine Differenz zwischen dem ersten Zündwinkel und dem zweiten Zündwinkel kleiner als eine maximale Differenz ist.

3. Verfahren (100) gemäß einem der vorstehenden Ansprüche, mit einem Schritt des Bestimmens (204) des ersten Zündwinkels, wobei der erste Zündwinkel unter Verwendung eines maximal zulässigen Stroms am Zwischenkreiskondensator (410) bestimmt wird und/oder mit einem Schritt des Bestimmens (204) des zweiten Zündwinkels, wobei der zweite Zündwinkel unter Verwendung des maximal zulässigen Stroms am Zwischenkreiskondensator (410) bestimmt wird.

4. Verfahren (100) gemäß einem der vorstehenden Ansprüche, mit einem Schritt des Ermittelns (200) einer Phasenlage der Halbwelle und einer Phasenlage der der Halbwelle nachfolgenden Halbwelle, wobei der erste Zündwinkel und der zweite Zündwinkel in den Schritten des Einspeisens (102, 104) unter Verwendung der Phasenlagen bestimmt werden.

5. Verfahren (100) gemäß einem der vorstehenden Ansprüche, mit einem ersten Schritt des Erfassens (202) einer Spannung des Zwischenkreiskondensators (410) vor dem ersten Schritt des Einspeisens (102), wobei der erste Zündwinkel unter Verwendung der Spannung vor dem Einspeisen bestimmt wird und/oder mit einem zweiten Schritt des Erfassens (202) der Spannung des Zwischenkreiskondensators (108) nach dem ersten Schritt des Einspeisens (102), wobei der zweite Zündwinkel unter Verwendung der Spannung nach dem ersten Einspeisen bestimmt wird.

6. Verfahren (100) gemäß Anspruch 5, bei dem der erste Zündwinkel einen Spannungswert der Halbwelle repräsentiert, der eine vorbestimmte Spannungsdifferenz größer ist, als die Spannung vor dem Einspeisen (104) und/oder der zweite Zündwinkel einen Spannungswert der nachfolgenden Halbwelle repräsentiert, der die vorbestimmte Spannungsdifferenz größer ist, als die Spannung nach dem ersten Einspeisen (102) liegt.

7. Verfahren (100) gemäß einem der vorstehenden Ansprüche, bei dem im Schritt des Einspeisens (102) der Spannung aus dem ersten Abschnitt (302a) die Halbwelle einen Teil einer ersten Phase (300a) einer Mehrphasenwechselspannung (406) repräsentiert, und bei dem im Schritt des Einspeisens (104) der Spannung aus dem zweiten Abschnitt (302b) die der Halbwelle nachfolgende Halbwelle einen Teil einer, um einen Phasenwinkel zu der Halbwelle verschobenen zweiten Phase (300b) der Mehrphasenwechselspannung (406) repräsentiert.

8. Verfahren (100) gemäß einem der vorstehenden Ansprüche, mit zumindest einem weiteren Schritt des Einspeisens, in dem eine Spannung aus einem weiteren Abschnitt (302) einer der Halbwelle oder der nachfolgenden Halbwelle weiter nachfolgenden Halbwelle der Wechselspannung (300) in den Zwischenkreiskondensator (410) eingespeist wird, wobei der weitere Abschnitt (302) bei einem weiteren Zündwinkel beginnt, der kleiner als der zweite Zündwinkel ist.

9. Steuergerät zum Laden (414) eines Zwischenkreiskondensators (410) für ein Schweißgerät (400), das Einheiten aufweist, die dazu ausgebildet sind, die Schritte eines Verfahrens (100) gemäß einem der Ansprüche 1 bis 9 durchzuführen:

10. Computer-Programm mit Programmcode zur Durchführung des Verfahrens (100) nach einem der Ansprüche 1 bis 9, wenn das Programm auf einer Vorrichtung (414) ausgeführt wird.

## Claims

1. Method (100) for charging a DC-link capacitor (408) for a welding device (400), wherein the method (100) comprises the following steps: feeding (102) a voltage from a first portion (302a) of a half-cycle of an AC voltage (300a) into the DC-link capacitor (410), wherein the first portion (302a) starts at a first ignition angle; and feeding (104) a voltage from a second portion (302b) of a half-cycle of the AC voltage (300b) that follows the half-cycle into the DC-link capacitor (410), wherein the second portion (302b) starts at a second ignition angle smaller than the first ignition angle, **characterized in that**
first in the chronological sequence of the method (100), one of the following four operating states of a system comprising the DC-link capacitor (408) is determined as being present by means of a superordinate controller:
- charging procedure
- generating a reduced voltage
- normal operation at a reduced ignition angle
- switching off
and wherein, depending on the operating state, a different amount of charge is introduced into the DC-link capacitor (408).

2. Method (100) according to Claim 1, wherein in the step of feeding in (104) the second portion (302b), a difference between the first ignition angle and the second ignition angle is smaller than a maximum difference.

3. Method (100) according to one of the preceding claims, comprising a step of determining (204) the first ignition angle, wherein the first ignition angle is determined using a maximum permissible current at the DC-link capacitor (410), and/or comprising a step of determining (204) the second ignition angle, wherein the second ignition angle is determined using the maximum permissible current at the DC-link capacitor (410).

4. Method (100) according to one of the preceding claims, comprising a step of determining (200) a phase of the half-cycle and a phase of the half-cycle that follows the half-cycle, wherein the first ignition angle and the second ignition angle are determined in the steps of feeding in (102, 104) using the phases.

5. Method (100) according to one of the preceding claims, comprising a first step of measuring (202) a voltage of the DC-link capacitor (410) before the first step of feeding in (102), wherein the first ignition angle is determined using the voltage before the feeding-in, and/or comprising a second step of measuring (202) the voltage of the DC-link capacitor (108) after the first step of feeding in (102), wherein the second ignition angle is determined using the voltage after the first feeding-in.

6. Method (100) according to Claim 5, wherein the first ignition angle represents a voltage value of the half-cycle that is a predetermined voltage difference greater than the voltage before the feeding-in (104), and/or the second ignition angle represents a voltage value of the subsequent half-cycle that is greater than the voltage after the first feeding-in (102) by the predetermined voltage difference.

7. Method (100) according to one of the preceding claims, wherein in the step of feeding in (102) the voltage from the first portion (302a), the half-cycle represents part of a first phase (300a) of a multiphase AC voltage (406), and wherein in the step of feeding in (104) the voltage from the second portion (302b), the half-cycle that follows the half-cycle represents part of a second phase (300b) of the multiphase AC voltage (406), which is shifted by a phase angle relative to the half-cycle.

8. Method (100) according to one of the preceding claims, comprising at least one further step of feeding in, in which a voltage from a further portion (302) of a half-cycle of the AC voltage (300) that additionally follows the half-cycle or the subsequent half-cycle is fed into the DC-link capacitor (410), wherein the further portion (302) starts at a further ignition angle smaller than the second ignition angle.

9. Control device for charging (414) a DC-link capacitor (410) for a welding device (400), having units which are designed to carry out the steps of a method (100) according to one of Claims 1 to 9.

10. Computer program having program code for carrying out the method (100) according to one of Claims 1 to 9 when the program is executed on an apparatus (414).

## Revendications

1. Procédé (100) de charge d'un condensateur (408) de circuit intermédiaire pour un appareil de soudage (400), le procédé (100) comprenant les étapes suivantes : alimenter (102) le condensateur (410) du circuit intermédiaire avec une tension provenant d'une première partie (302a) d'une demi-onde d'une tension alternative (300a), la première partie (302a) commençant à un premier angle d'amorçage ; et alimenter (104) le condensateur (410) du circuit intermédiaire avec une tension provenant d'une deuxième partie (302b) d'une demi-onde de la tension alternative (300b) qui suit la demi-onde, la deuxième partie (302b) commençant à un deuxième angle d'amorçage qui est inférieur au premier angle d'amorçage, **caractérisé en ce que**
en premier lieu, dans le déroulement temporel du procédé (100), l'un des quatre états de fonctionnement suivants d'un système comprenant le condensateur (408) de circuit intermédiaire est déterminé comme étant présent au moyen d'une commande de niveau supérieur :
- processus de charge
- génération d'une tension réduite
- fonctionnement normal avec angle d'amorçage réduit
- mise hors tension,
et dans lequel, selon l'état de fonctionnement, une quantité de charge différente est introduite dans le condensateur (408) de circuit intermédiaire.

2. Procédé (100) selon la revendication 1, dans lequel, lors de l'étape d'alimentation (104) de la deuxième section (302b), une différence entre le premier angle d'amorçage et le deuxième angle d'amorçage est inférieure à une différence maximale.

3. Procédé (100) selon l'une des revendications précédentes, comprenant une étape (204) de détermination du premier angle d'amorçage, le premier angle d'amorçage étant déterminé en utilisant un courant maximal admissible au niveau du condensateur (410) du circuit intermédiaire et/ou comprenant une étape (204) de détermination du deuxième angle d'amorçage, le deuxième angle d'amorçage étant déterminé en utilisant le courant maximal admissible au niveau du condensateur (410) du circuit intermédiaire.

4. Procédé (100) selon l'une des revendications précédentes, comprenant une étape de détermination (200) d'une relation de phase de la demi-onde et d'une relation de phase de la demi-onde qui suit la demi-onde, le premier angle d'amorçage et le deuxième angle d'amorçage étant déterminés dans les étapes d'alimentation (102, 104) en utilisant les relations de phase.

5. Procédé (100) selon l'une des revendications précédentes, comprenant une première étape de détection (202) d'une tension du condensateur (410) du circuit intermédiaire avant la première étape d'alimentation (102), le premier angle d'amorçage étant déterminé en utilisant la tension avant l'alimentation et/ou comprenant une deuxième étape de détection (202) de la tension du condensateur de circuit intermédiaire (108) après la première étape d'alimentation (102), le deuxième angle d'amorçage étant déterminé en utilisant la tension après la première alimentation.

6. Procédé (100) selon la revendication 5, dans lequel le premier angle d'amorçage représente une valeur de tension de la demi-onde qui est supérieure d'une différence de tension prédéterminée à la tension avant l'alimentation (104) et/ou le deuxième angle d'amorçage représente une valeur de tension de la demi-onde suivante qui est supérieure de la différence de tension prédéterminée avec la tension après la première alimentation (102).

7. Procédé (100) selon l'une des revendications précédentes, dans lequel, lors de l'étape d'alimentation (102) de la tension provenant de la première section (302a), la demi-onde représente une partie d'une première phase (300a) d'une tension alternative polyphasée (406), et dans lequel, lors de l'étape d'alimentation (104) de la tension provenant de la deuxième section (302b), la demi-onde suivant la demi-onde représente une partie d'une deuxième phase (300b) de la tension alternative polyphasée (406) décalée d'un angle de phase par rapport à la demi-onde.

8. Procédé (100) selon l'une des revendications précédentes, comprenant au moins une autre étape d'alimentation, dans laquelle une tension provenant d'une autre partie (302) de l'une des demi-ondes ou de la demi-onde suivante de la tension alternative (300) est alimentée dans le condensateur (410) du circuit intermédiaire, l'autre partie (302) commençant à un autre angle d'amorçage qui est inférieur au deuxième angle d'amorçage.

9. Appareil de commande pour charger (414) un condensateur (410) du circuit intermédiaire pour un appareil de soudage (400), qui comprend des unités conçues pour mettre en œuvre les étapes d'un procédé (100) selon l'une des revendications 1 à 9.

10. Programme informatique avec code de programme pour la mise en œuvre du procédé (100) selon l'une des revendications 1 à 9, lorsque le programme est exécuté sur un dispositif (414).
